# EUROPEAN PATENT APPLICATION

(11) **EP 3 553 542 A1**
(43) Date of publication of application: **16.10.2019**
(21) Application number: 18167333.6
(22) Date of filing: 13.04.2018
(51) Int. Cl.: G01R 31/28

(54) **TESTING ASSEMBLY**

(71) Applicant: General Electric Technology GmbH, 5400 Baden (CH)
(72) Inventor: CHIVITE-ZABALZA, Francisco Javier, Stafford, Staffordshire ST16 1WS (GB); OLALQUIAGA SAN EMETERIO, Mikel, Stafford, Staffordshire ST16 1WS (GB); REES, David, Stafford, Staffordshire ST16 1WS (GB); LI, Xiaoming, Stafford, Staffordshire ST16 1WS (GB)
(74) Representative: Brevalex

(57) **Abstract**

There is provided a testing assembly (20,120,220) for a plurality of electrical devices. The testing assembly (20,120,220) comprises:
at least one testing circuit (22) for carrying out at least one electrical test on the plurality of electrical devices;
a plurality of electrical couplers connected to the or each testing circuit (22), the plurality of electrical couplers including a plurality of first electrical couplers, each first electrical coupler arranged to be connectable to a respective one of the plurality of electrical devices so as to couple the respective electrical device to the or each testing circuit (22), each first electrical coupler arranged to be configurable to selectively electrically connect the respective electrical device to the or each testing circuit (22) and electrically disconnect the respective electrical device from the or each testing circuit (22); and
a control unit (34) programmed to selectively control the configuration of the plurality of electrical couplers to electrically connect the or each testing circuit (22) to one or more selected electrical devices from the plurality of electrical devices.

## Description

This invention relates to a testing assembly for carrying out at least one electrical test on a plurality of electrical devices.

It is known to use a testing circuit to carry out an electrical test on an electrical component to assess its capabilities and performance.

According to an aspect of the invention, there is provided a testing assembly for a plurality of electrical devices, the testing assembly comprising:
at least one testing circuit for carrying out at least one electrical test on the plurality of electrical devices;
a plurality of electrical couplers connected to the or each testing circuit, the plurality of electrical couplers including a plurality of first electrical couplers, each first electrical coupler arranged to be connectable to a respective one of the plurality of electrical devices so as to couple the respective electrical device to the or each testing circuit, each first electrical coupler arranged to be configurable to selectively electrically connect the respective electrical device to the or each testing circuit and electrically disconnect the respective electrical device from the or each testing circuit; and
a control unit programmed to selectively control the configuration of the plurality of electrical couplers to electrically connect the or each testing circuit to one or more selected electrical devices from the plurality of electrical devices.

The provision of the plurality of electrical couplers and the control unit in the testing assembly of the invention allows each electrical device to be pre-connected to the or each testing circuit prior to the selective electrical connection of the or each selected electrical device to the or each testing circuit to enable the initiation of the or each electrical test. This obviates the need for human operator interaction to manually electrically connect the or each selected electrical device to the or each testing circuit before initiating the or each electrical test. Removing the need for the human operator interaction not only improves the safety of the electrical testing procedure by minimising the exposure of the human operator to live electrical devices, but also improves efficiency by reducing the time required to carry out an electrical testing procedure and by increasing the availability of the human operator to carry out other tasks.

The provision of the plurality of electrical couplers and the control unit in the testing assembly of the invention also not only allows for an automatic and flexible electrical testing procedure in which the control unit may be programmed to control the configuration of the plurality of electrical couplers so as to test the plurality of electrical devices using a wide range of test sequences and patterns, but also readily permits the electrical reconnection of a previously tested electrical device in the event that an electrical retest is required.

The plurality of electrical couplers may be arranged in various ways depending on testing requirements of the testing assembly. The features of the plurality of electrical couplers are such that the testing assembly can be readily designed to not only accommodate multiple electrical tests to further reduce the time required to carry out the electrical testing procedure but also to permit the testing assembly with an expandable testing capability by providing it with the capacity to incorporate one or more electrical tests in future.

In embodiments of the invention, the plurality of electrical couplers may be arranged in a multiplex circuit arrangement for forming a multiplex connection between the plurality of electrical devices and the or each testing circuit.

Employing a multiplex connection between the plurality of electrical devices and the or each testing circuit permits a more efficient use of hardware resources, especially with respect to duplicate hardware carrying out identical functions, which in turn results in a more compact, cheaper and reliable testing assembly.

In a preferred embodiment of the invention employing the use of the multiplex circuit arrangement, the testing assembly may further include at least one busbar connected to the or each testing circuit, each first electrical coupler connected to the or each busbar, each first electrical coupler arranged to be configurable to selectively electrically connect the respective electrical device to the or each busbar and electrically disconnect the respective electrical device from the or each busbar.

The or each busbar provides a reliable means for forming the multiplex connection between the plurality of electrical devices and the or each testing circuit. Also, the provision of the or each busbar in the testing assembly makes it simpler to simultaneously carry out the same electrical test on multiple devices.

In further embodiments of the invention, the plurality of electrical couplers may further include at least one second electrical coupler, the or each second electrical coupler arranged to interconnect the or each busbar to the or each testing circuit, the or each second electrical coupler arranged to be configurable to selectively electrically connect the or each busbar to the or each testing circuit and electrically disconnect the or each busbar from the or each testing circuit.

The combination of the or each busbar and the or each second electrical coupler in the testing assembly of the intention makes it simple to electrically connect multiple electrical devices to the or each testing circuit and electrically disconnect multiple devices from the or each testing circuit.

Moreover, the or each second electrical coupler provides the testing assembly with further options for controlling the configuration of the plurality of electrical couplers to electrically connect the or each testing circuit to one or more selected electrical devices from the plurality of electrical devices, which enables the testing assembly to accommodate one or more additional electrical tests to further reduce the time required to carry out the electrical testing procedure.

For example, when the testing assembly includes two busbars, the or each second electrical coupler may be arranged to be configurable to selectively allow the or each testing circuit to apply a voltage of either polarity across the two busbars when electrically connecting the two busbars to the or each testing circuit. In this example, the two busbars may be connected to the or each testing circuit via a second electrical coupler in the form of a double-pole double-throw switch.

In still further embodiments of the invention, the plurality of electrical couplers may include at least one third electrical coupler, the or each third electrical coupler arranged to be connectable to a given or respective one of the plurality of electrical devices so as to couple the given or respective electrical device to the or each testing circuit, the or each third electrical coupler arranged to be configurable to selectively electrically connect the given or respective electrical device to the or each testing circuit and electrically disconnect the given or respective electrical device from the or each testing circuit, the or each third electrical coupler further including a passive electrical component. The or each passive electrical component may be a resistive element.

The or each third electrical coupler not only provides the testing assembly with further options for controlling the configuration of the plurality of electrical couplers to electrically connect the or each testing circuit to one or more selected electrical devices from the plurality of electrical devices, but also enables the testing assembly to use the or each passive electrical component to carry out one or more additional electrical tests.

Optionally the or each third electrical coupler may be connected in parallel with the given or respective first electrical coupler. This permits the control unit to readily change the configuration of the plurality of electrical couplers to switch between different electrical tests.

The testing assembly of the invention may further include the plurality of electrical devices, wherein each first electrical coupler may be arranged to be connected to a respective one of the plurality of electrical devices so as to couple the respective electrical device to the or each testing circuit.

The invention is applicable to the testing of various types of electrical devices. Optionally each of the plurality of electrical devices may include a switch (such as a semiconductor switch). Further optionally the plurality of electrical devices may define a switch valve (such as a semiconductor switch valve) with a plurality of switch levels, each of the plurality of electrical devices defining a respective one of the plurality of switch levels. For example, the switch valve may be a thyristor valve and each switch level may be a thyristor level. Each switch level includes a switching device (e.g. a semiconductor switching device), and may additionally include a switching aid component or circuit and/or any auxiliary components to assist the operation of the switching device.

In embodiments of the invention, an end switch level of the switch valve may be short-circuited to another end switch level of the switch valve. Short-circuiting the switch valve in this manner also enables the testing assembly to accommodate one or more additional electrical tests so as to further reduce the time taken to carry out the electrical testing procedure.

In further embodiments of the invention, each electrical coupler may include a switching element which is switchable to selectively form and break an electrical connection. This provides each electrical coupler with a reliable means for carrying out the electrical connection and disconnection. It will be appreciated that each electrical coupler may take a different form so long as each electrical coupler is capable of selectively forming and breaking an electrical connection.

In still further embodiments of the invention, the testing assembly may further include a testing circuit controller programmed to selectively control the or each testing circuit to carry out at least one electrical test on the or each selected electrical device. The or each electrical test may include testing, for example, the voltage and/or power supply characteristics of the or each selected device.

In a preferred embodiment of the invention, the testing assembly may be configured for use in a HVDC application. The invention is particularly useful for minimising the exposure of the human operator to live electrical devices operating at high voltage levels.

It will be appreciated that the use of the terms "first", "second" and "third", and the like, in this patent specification is merely intended to help distinguish between similar features (e.g. the first, second and third electrical couplers), and is not intended to indicate the relative importance of one feature over another feature, unless otherwise specified.

Preferred embodiments of the invention will now be described, by way of non-limiting examples, with reference to the accompanying drawings in which:
Figure 1 shows schematically a testing assembly according to a first embodiment of the invention;
Figures 2 and 3 illustrate configurations of a plurality of electrical couplers of the testing assembly of Figure 1;
Figure 4 shows schematically a testing assembly according to a second embodiment of the invention;
Figures 5 to 7 illustrate configurations of a plurality of electrical couplers of the testing assembly of Figure 4;
Figure 8 shows schematically a testing assembly according to a third embodiment of the invention; and
Figures 9 to 11 illustrate configurations of a plurality of electrical couplers of the testing assembly of Figure 8.

The figures are not necessarily to scale, and certain features and certain views of the figures may be shown exaggerated in scale or in schematic form in the interests of clarity and conciseness.

The following embodiments of the invention are used primarily in HVDC applications, but it will be appreciated that the following embodiments of the invention are applicable mutatis mutandis to other applications operating at different voltage levels.

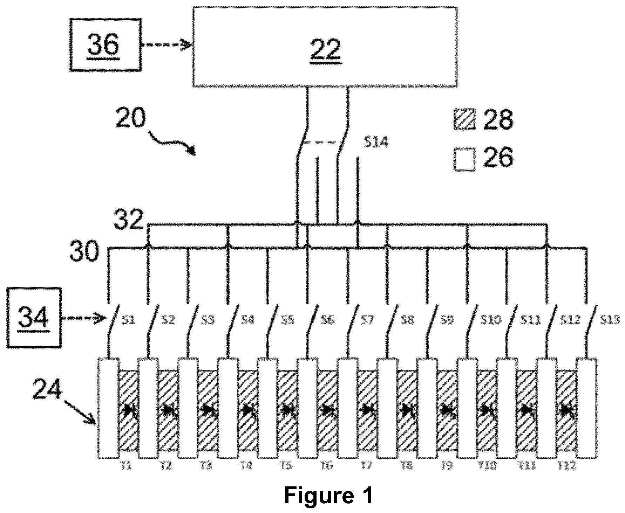

A testing assembly according to a first embodiment of the invention is shown in Figure 1 and is designated generally by the reference numeral 20.

The testing assembly 20 includes a testing circuit in the form of a valve test equipment (VTE) 22 which is designed to perform an electrical test on a thyristor valve 24. The VTE 22 is used at the end of the manufacturing line to check that the thyristor valve 24 is correctly assembled and that passive and active components of the thyristor valve 24 are within tolerance levels and fit for purpose. It will be appreciated that the VTE 22 may be used at any other stage and/or for any other purposes. It will also be appreciated that the VTE 22 may be replaced by, or combined with, a different type of testing circuit, such as a partial discharge testing circuit, a heat run testing circuit, and so on.

The thyristor valve 24 comprises a plurality of thyristor levels (indicated by T1 to T12 in Figure 1) and further comprises a plurality of heat sinks 26 arranged in a cascade arrangement such that each thyristor level T1 to T12 is sandwiched between two of the plurality of heat sinks 26. Each thyristor level 26 includes a respective thyristor 28, passive components (e.g. damping resistors/capacitors and grading resistors), and thyristor level electronics (e.g. a gate driver and voltage dividers).

The testing assembly 20 includes a plurality of electrical couplers in the form of single-pole single-throw (SPST) high voltage switches, which are indicated as S1 to S13 in Figure 1. In the embodiment shown, each SPST switch S1 to S13 is connected to a respective one of the heat sinks 26, but in alternative embodiments may be directly connected to terminals of the thyristors 28. In the embodiment shown, each heat sink 26 defines a connection point which is electrically the same point as the or each terminal of the thyristors 28 to which the heat sink 26 is connected. Each of the odd-numbered SPST switches S1, S3, S5, S7, S9, S11, S13 are arranged to connect the corresponding heat sink 26 to a first busbar 30, and each of the even-numbered SPST switches S2, S4, S6, S8, S10, S12 are arranged to connect the corresponding heat sink 26 to a second busbar 32. In use, each SPST switch S1 to S13 is switchable to selectively electrically connect the respective thyristor level T1 to T12 to the corresponding busbar 30,32 and electrically disconnect the respective thyristor level T1 to T12 from the corresponding busbar 30,32.

The testing assembly 20 further includes another electrical coupler in the form of a double-pole double-throw (DPDT) switch S14 which is arranged to interconnect the first and second busbars 30,32 to the VTE 22. In use, the DPDT switch S14 is switchable to selectively electrically connect the busbars 30,32 to the VTE 22 and electrically disconnect the busbars 30,32 from the VTE 22. More particularly, the DPDT switch S14 is arranged to be switchable to either of two positions to enable the VTE 22 to apply a voltage of either polarity across the two busbars 30,32.

The multiplex circuit arrangement of the SPST switches S1 to S13, the busbars 30,32 and the DPDT switch S14 in the testing assembly 20 results in the formation of a multiplex connection between the thyristor levels T1 to T12 and the VTE 22. In this way the thyristor levels T1 to T12 are pre-connected to the VTE 22 before the electrical test on the thyristor valve 24 is carried out.

The testing assembly 20 further includes a control unit 34 programmed to selectively control the switching of the SPST and DPDT switches S1 to S13, S14 in order to control the configuration of the SPST and DPDT switches S1 to S13, S14 so that the VTE 22 is electrically connected to one or more selected thyristor levels T1 to T12. The testing assembly 20 further includes a VTE controller 36 programmed to selectively control the VTE 22 to carry out the electrical test on the or each selected thyristor level T1 to T12. It will be appreciated that the control units 34,36 may be separate distinct control units, or the control units 34,36 may be replaced by a single control unit capable of performing the same control functions, or the controls units 34,36 may be distributed controllers forming part of the same control system.

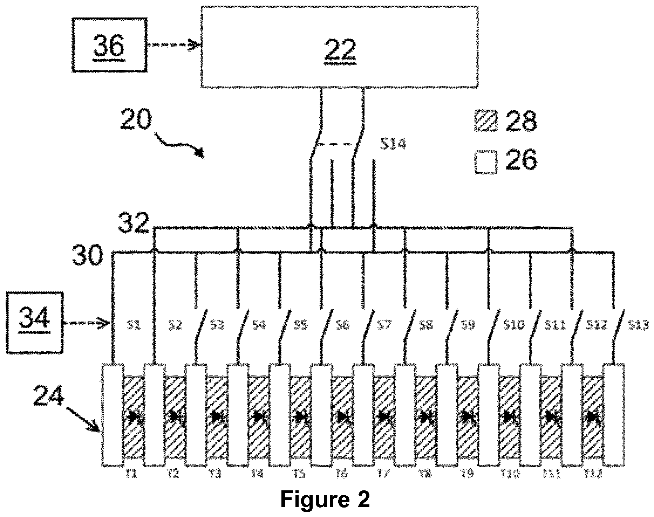

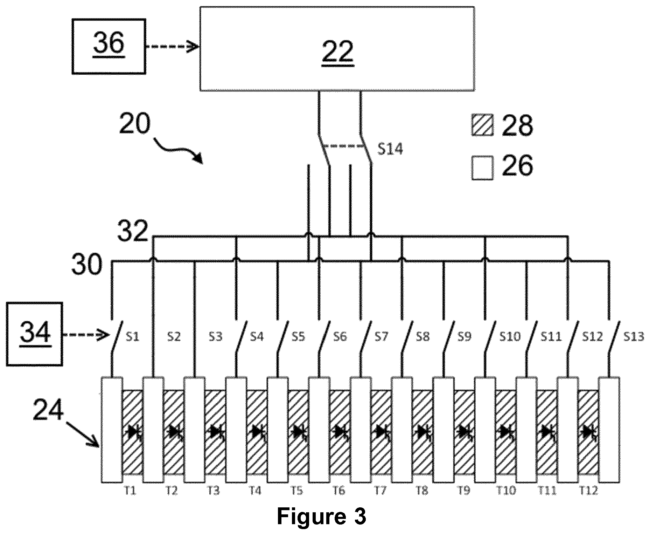

Figures 2 and 3 illustrate uses of the testing assembly 20 to carry out a selective electrical connection of the VTE 22 to a specific thyristor level T1, T2.

In Figure 2, the SPST switches S1, S2 are turned on and the remaining SPST switches S3 to S13 are turned off to connect the busbars 30,32 to the first thyristor level T1, while the DPDT switch S14 is switched to a first position to apply a voltage of a first polarity across the busbars 30,32. This enables the VTE 22 to apply the voltage of the first polarity to the first thyristor level T1 in order to carry out an electrical test on the first thyristor level T1.

In Figure 2, the SPST switches S2, S3 are turned on and the remaining SPST switches S1, S4 to S13 are turned off to connect the busbars 30,32 to the second thyristor level T2, while the DPDT switch S14 is switched to a second position to apply a voltage of a second, opposite polarity across the busbars 30,32. This enables the VTE 22 to apply the voltage of the opposite polarity to the second thyristor level T2 in order to carry out an electrical test on the second thyristor level T2.

The multiplex connection between the thyristor levels T1 to T12 and the VTE 22 permits the switching of the SPST switches S1 to S13 to enable the VTE 22 to apply a voltage of either polarity to any of the thyristor levels T1 to T12. The SPST switches S1 to S13 may be switched to enable the VTE 22 to apply a voltage of either polarity to multiple thyristor levels T1 to T12 simultaneously. For example, the SPST switches S1 to S13 may be switched to enable the VTE 22 to apply a voltage of either polarity to multiple alternate thyristor levels simultaneously, e.g. multiple odd-numbered thyristor levels T1, T3, T5 simultaneously or multiple even-numbered thyristor levels T2, T4, T6 simultaneously. Furthermore, the SPST switches S1 to S13 can be switched to enable the VTE 22 to apply a voltage of either polarity to the thyristor levels T1 to T12 using any test sequence or pattern (e.g. apply a voltage of either polarity to the thyristor levels T1 to T12 one at a time) depending on testing requirements of the thyristor valve 24. If a previously tested thyristor level T1 to T12 requires retesting, the SPST switches S1 to S13 can be readily switched to electrically reconnect the previously tested thyristor level T1 to T12 to the VTE 22.

Since the switching of the SPST switches S1 to S13 is controlled by the control unit 34, human operator interaction is not required to manually modify the electrical connections between the thyristor levels T1 to T12 and the VTE 22 before proceeding to the next electrical test, which minimises or eliminates the requirement for a human operator to access the testing assembly 20 in order to change the electrical connections between the thyristor levels T1 to T12 and the VTE 22. This not only provides time savings due to the reduction or elimination of human operation interaction to manually modify the electrical connections between the thyristor levels T1 to T12 and the VTE 22, but also improves electrical safety for the human operator due to the reduction in the number of times that the human operator is exposed to electrical safety hazards when accessing potentially live components of the testing assembly 20. Also, during the electrical testing of the thyristor valve 24, the human operator does not need to be physically present at the testing assembly 20 and thereby is available to carry out other tasks such as preparing the next thyristor valve for testing.

Further time savings can be obtained by controlling the VTE 22 to carry out multiple electrical tests in sequence or in parallel.

The provision of the busbars 30,32 makes it straightforward to connect other test equipment (e.g. another testing circuit) to the thyristor levels T1 to T12, since there is no need to make individual electrical connections between the other test equipment and each thyristor level T1 to T12. This is because the selective connection of the other test equipment to the different thyristor levels T1 to T12 is possible using the multiplex circuit arrangement of the SPST switches S1 to S13, the busbars 30,32 and the DPDT switch S14 in the testing assembly 20. This allows expansion of the testing capability of the testing assembly 20 to incorporate one or more other electrical tests.

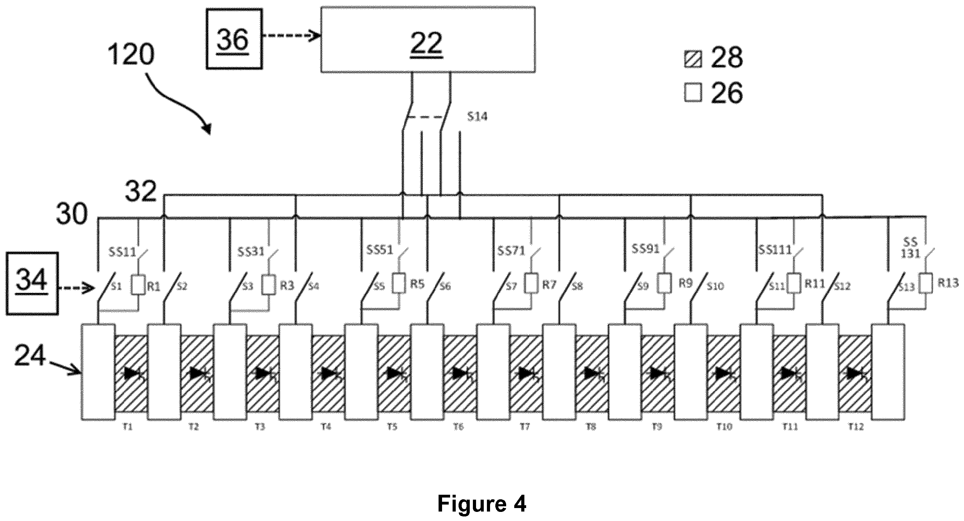

A testing assembly according to a second embodiment of the invention is shown in Figure 4 and is designated generally by the reference numeral 120. The testing assembly 120 of Figure 4 is similar in structure and operation to the testing assembly 20 of Figure 1 and like features share the same reference numerals

The testing assembly 120 of Figure 4 differs from the testing assembly 20 of Figure 1 in that the testing assembly 120 of Figure 4 further includes a plurality of further couplers. Each further electrical coupler includes a resistor (indicated by R1, R3, R5, R7, R9, R11, R13 in Figure 4) connected in series with a SPST switch (indicated by SS11, SS31, SS51, SS71, SS111, SS131 in Figure 4). Each further electrical coupler is connected in parallel with a respective one of the odd-numbered SPST switches S1, S3, S5, S7, S9, S11, S13 connected to the first busbar 30.

In use, the SPST switch SS11, SS31, SS51, SS71, SS111, SS131 is switchable to selectively electrically connect the respective thyristor level T1 to T12 to the first busbar 30 and electrically disconnect the respective thyristor level T1 to T12 from the first busbar 30.

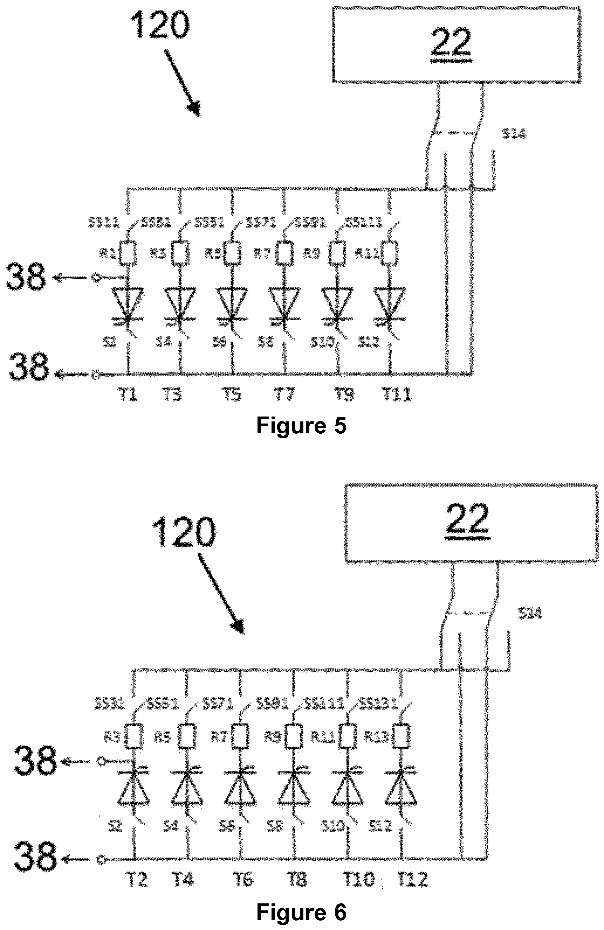

The provision of the further electrical couplers in the testing assembly 120 increases the number of possible configurations of the plurality of electrical couplers so as to enable the VTE 22 to perform different electrical tests on the thyristor valve 24. It will be appreciated that the plurality of electrical couplers may be configured to enable the different electrical tests to be performed separately or simultaneously. Figures 5 to 7 illustrate exemplary configurations of the plurality of electrical couplers to permit the VTE 22 to carry out a thyristor electronics power supply storage test on multiple thyristor levels T1 to T12 at the same time.

In Figure 5, the SPST switches S2, S4, S6, S8, S10, S12 and the SPST switches SS11, SS31, SS51, SS71, SS91, SS111 are switched to electrically connect the anode of the thyristor 28 of each of the thyristor levels T1, T3, T5, T7, T9, T11 in series with a respective one of the resistors R1, R3, R5, R7, R9, R11 corresponding to the SPST switches SS11, SS31, SS51, SS71, SS91, SS111 such that the VTE 22 via the switching of the DPDT switch S14 is permitted to provide a voltage across the thyristor levels T1, T3, T5, T7, T9, T11. Meanwhile the remaining SPST switches S1, S3, S5, S7, S9, S11, S13, SS131 stay turned off so that the thyristor levels T2, T4, T6, T8, T10, T12 are switched out of circuit. This enables the thyristor electronics power supply storage test to be carried out on the thyristor levels T1, T3, T5, T7, T9, T11 simultaneously.

In Figure 6, the SPST switches S2, S4, S6, S8, S10, S12 and the SPST switches SS31, SS51, SS71, SS91, SS111, SS131 are switched to electrically connect the cathode of the thyristor 28 of each of the thyristor levels T2, T4, T6, T8, T10, T12 in series with a respective one of the resistors R3, R5, R7, R9, R11, R13 corresponding to the SPST switches SS31, SS51, SS71, SS91, SS111, SS131 such that the VTE 22 via the switching of the DPDT switch S14 is permitted to provide a voltage across the thyristor levels T2, T4, T6, T8, T10, T12. Meanwhile the SPST switches S1, S3, S5, S7, S9, S11, S13, SS11 stay turned off so that the thyristor levels T1, T3, T5, T7, T9, T11 are switched out of circuit. This enables the thyristor electronics power supply storage test to be carried out on the thyristor levels T2, T4, T6, T8, T10, T12 simultaneously.

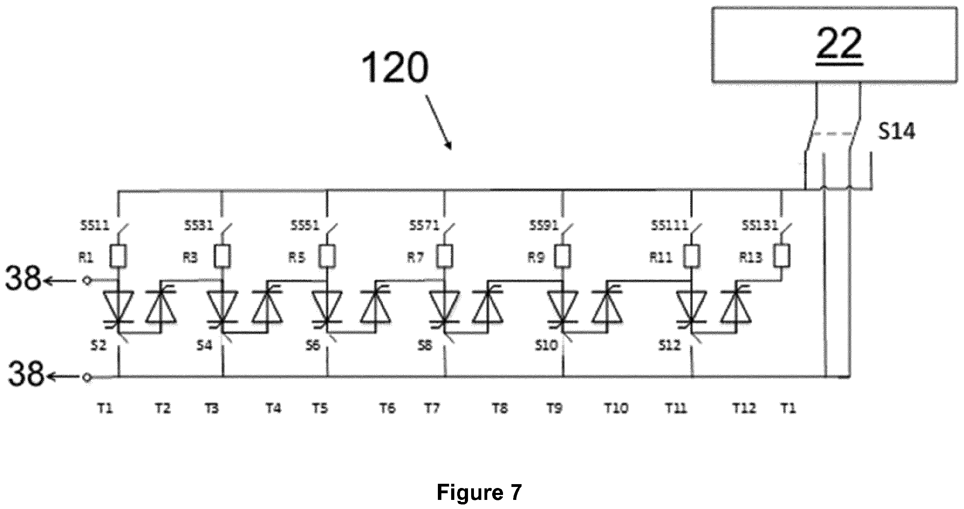

The configuration of the SPST switches S1 to SS131 in Figure 7 is similar to the configuration of the SPST switches S1 to SS131 shown in Figure 5, except that the SPST switch SS131 is also switched such that the thyristor levels T2, T4, T6, T8, T10, T12 are switched into circuit. Hence, the thyristor electronics power supply storage test can be performed on all of the thyristor levels T1 to T12 at the same time. Meanwhile the remaining SPST switches S1, S3, S5, S7, S9, S11, S13 stay turned off. This enables the thyristor electronics power supply storage test to be carried out by simultaneously charging the thyristors 28 of the odd-numbered thyristor levels T1, T3, T5, T7, T9, T11 in a positive cycle of an applied waveform and simultaneously charging the thyristors 28 of the even-numbered thyristor levels T2, T4, T6, T8, T10, T12 in a negative cycle of the applied waveform.

In each of Figures 5 to 7, a high voltage probe 38 is used to measure the thyristor voltage during the thyristor electronics power supply storage test.

The ability to perform out the thyristor electronics power supply storage test on multiple thyristor levels T1 to T12 at the same time provides further time savings for the electrical testing of the thyristor valve 24.

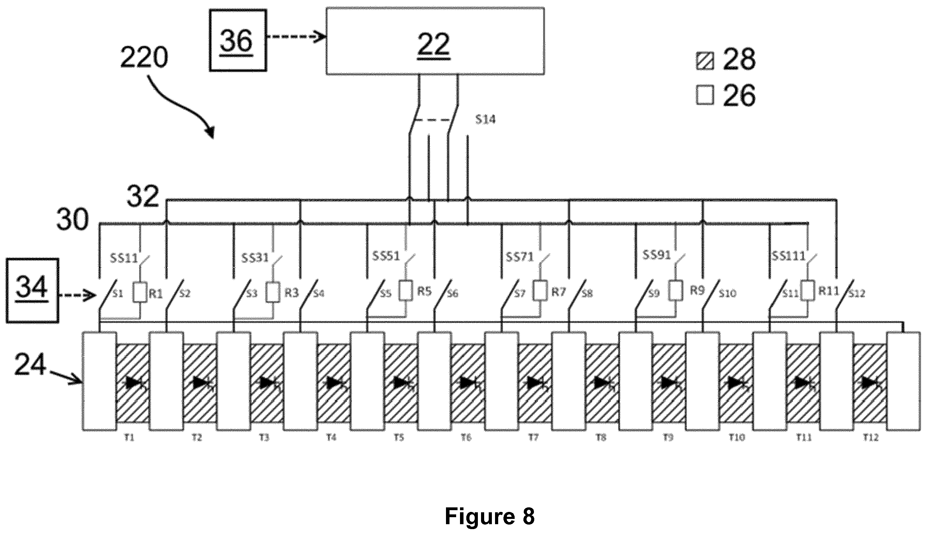

A testing assembly according to a third embodiment of the invention is shown in Figure 8 and is designated generally by the reference numeral 220. The testing assembly 220 of Figure 8 is similar in structure and operation to the testing assembly 120 of Figure 4 and like features share the same reference numerals

The testing assembly 220 of Figure 8 differs from the testing assembly 120 of Figure 4 in that the testing assembly 220 of Figure 8 omits the electrical couplers connected to the heat sink 26 which is connected to the end thyristor level T12 and is located at the end of the thyristor valve 24. Thus, the SPST switches S13, SS131 and the resistor R13 is omitted from the testing assembly 220.

The testing assembly 220 further includes a short-circuit between the heat sinks 26 which are respectively connected to the end thyristor levels T1, T12 and are located at respective ends of the thyristor valve 24.

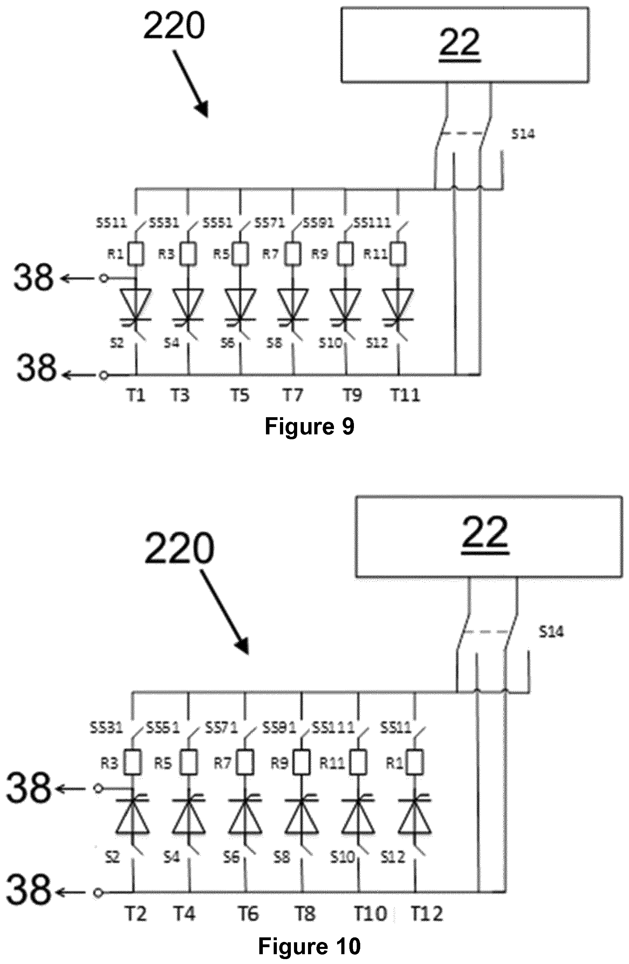

Figures 9 to 11 illustrate exemplary configurations of the plurality of SPST switches S1 to S111 to permit the VTE 22 to carry out a thyristor electronics power supply storage test on multiple thyristor levels T1 to T12 at the same time.

In Figure 9, the SPST switches S2, S4, S6, S8, S10, S12 and the SPST switches SS11, SS31, SS51, SS71, SS91, SS111 are switched to electrically connect the anode of the thyristor 28 of each of the thyristor levels T1, T3, T5, T7, T9, T11 in series with a respective one of the resistors R1, R3, R5, R7, R9, R11 corresponding to the SPST switches SS11, SS31, SS51, SS71, SS91, SS111 such that the VTE 22 via the switching of the DPDT switch S14 is permitted to provide a voltage across the thyristor levels T1, T3, T5, T7, T9, T11. Meanwhile the remaining SPST switches S1, S3, S5, S7, S9, S11, S13 stay turned off so that the thyristor levels T2, T4, T6, T8, T10, T12 are switched out of circuit. This enables the thyristor electronics power supply storage test to be carried out on the thyristor levels T1, T3, T5, T7, T9, T11 simultaneously.

In Figure 10, the SPST switches S2, S4, S6, S8, S10, S12 and the SPST switches SS31, SS51, SS71, SS91, SS111, SS11 are switched to electrically connect the cathode of each of the thyristor levels T2, T4, T6, T8, T10, T12 in series with a respective one of the resistors R3, R5, R7, R9, R11, R1 corresponding to the SPST switches SS31, SS51, SS71, SS91, SS111, SS11 such that the VTE 22 via the switching of the DPDT switch S14 is permitted to provide a voltage across the thyristor levels T2, T4, T6, T8, T10, T12. Meanwhile the SPST switches S1, S3, S5, S7, S9, S13 stay turned off so that the thyristor levels T1, T3, T5, T7, T9, T11 are switched out of circuit. This enables the thyristor electronics power supply storage test to be carried out on the thyristor levels T2, T4, T6, T8, T10, T12 simultaneously.

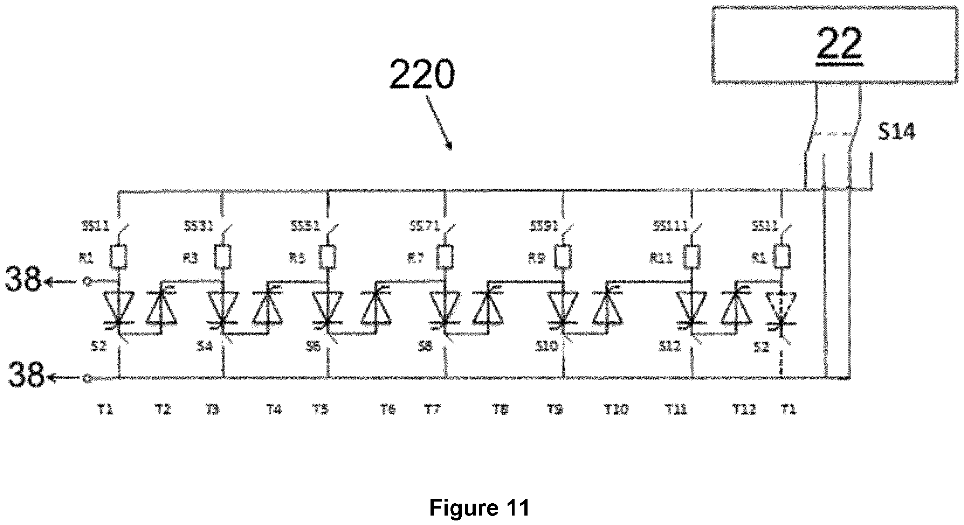

The configuration of the SPST switches S1 to SS111 in Figure 11 is similar to the configuration of the SPST switches S1 to SS111 shown in Figure 9, except that the short-circuit results in the thyristor levels T2, T4, T6, T8, T10, T12 being switched into circuit. Hence, the thyristor electronics power supply storage test can be performed on all of the thyristor levels T1 to T12 at the same time. Meanwhile the remaining SPST switches S1, S3, S5, S7, S9, S11 stay turned off. This enables the thyristor electronics power supply storage test to be carried out by simultaneously charging the thyristors 28 of the odd-numbered thyristor levels T1, T3, T5, T7, T9, T11 in a positive cycle of an applied waveform and simultaneously charging the thyristors 28 of the even-numbered thyristor levels T2, T4, T6, T8, T10, T12 in a negative cycle of the applied waveform. It will be appreciated that the thyristor level T1 is depicted twice in Figure 11 for illustrative purposes to demonstrate the electrical connections of the thyristor levels T1 to T12 to the VTE 22.

In each of Figures 9 to 11, a high voltage probe 38 is used to measure the thyristor voltage during the thyristor electronics power supply storage test.

It is envisaged that, in other embodiments of the invention, the thyristor valve 24 may be replaced by a different electrical device to be tested, such as another type of switch valve, preferably another type of semiconductor switch valve.

## Claims

1. A testing assembly (20,120,220) for a plurality of electrical devices, the testing assembly (20,120,220) comprising:
at least one testing circuit (22) for carrying out at least one electrical test on the plurality of electrical devices;
a plurality of electrical couplers connected to the or each testing circuit (22), the plurality of electrical couplers including a plurality of first electrical couplers, each first electrical coupler arranged to be connectable to a respective one of the plurality of electrical devices so as to couple the respective electrical device to the or each testing circuit (22), each first electrical coupler arranged to be configurable to selectively electrically connect the respective electrical device to the or each testing circuit (22) and electrically disconnect the respective electrical device from the or each testing circuit (22); and
a control unit (34) programmed to selectively control the configuration of the plurality of electrical couplers to electrically connect the or each testing circuit (22) to one or more selected electrical devices from the plurality of electrical devices.

2. A testing assembly (20,120,220) according to any one of the preceding claims wherein the plurality of electrical couplers is arranged in a multiplex circuit arrangement for forming a multiplex connection between the plurality of electrical devices and the or each testing circuit (22).

3. A testing assembly (20,120,220) according to Claim 2 further including at least one busbar (30,32) connected to the or each testing circuit (22), each first electrical coupler connected to the or each busbar (30,32), each first electrical coupler arranged to be configurable to selectively electrically connect the respective electrical device to the or each busbar (30,32) and electrically disconnect the respective electrical device from the or each busbar (30,32).

4. A testing assembly (20,120,220) according to Claim 3 wherein the plurality of electrical couplers further includes at least one second electrical coupler, the or each second electrical coupler arranged to interconnect the or each busbar (30,32) to the or each testing circuit (22), the or each second electrical coupler arranged to be configurable to selectively electrically connect the or each busbar (30,32) to the or each testing circuit (22) and electrically disconnect the or each busbar (30,32) from the or each testing circuit (22).

5. A testing assembly (20,120,220) according to Claim 4 wherein the testing assembly (20,120,220) includes two busbar (30,32), the or each second electrical coupler arranged to be configurable to selectively allow the or each testing circuit (22) to apply a voltage of either polarity across the two busbar (30,32) when electrically connecting the two busbar (30,32) to the or each testing circuit (22).

6. A testing assembly (120,220) according to any one of the preceding claims wherein the plurality of electrical couplers includes at least one third electrical coupler, the or each third electrical coupler arranged to be connectable to a given or respective one of the plurality of electrical devices so as to couple the given or respective electrical device to the or each testing circuit (22), the or each third electrical coupler arranged to be configurable to selectively electrically connect the given or respective electrical device to the or each testing circuit (22) and electrically disconnect the given or respective electrical device from the or each testing circuit (22), the or each third electrical coupler further including a passive electrical component.

7. A testing assembly (120,220) according to Claim 6 wherein the or each passive electrical component is a resistive element (R1, R3, R5, R7, R9, R11, R13).

8. A testing assembly (120,220) according to Claim 6 or Claim 7 wherein the or each third electrical coupler is connected in parallel with the given or respective first electrical coupler.

9. A testing assembly (20,120,220) according to any one of the preceding claims further including the plurality of electrical devices, wherein each first electrical coupler is arranged to be connected to a respective one of the plurality of electrical devices so as to couple the respective electrical device to the or each testing circuit (22).

10. A testing assembly (20,120,220) according to Claim 9 wherein each of the plurality of electrical devices includes a switch (28).

11. A testing assembly (20,120,220) according to Claim 10 wherein the plurality of electrical devices defines a switch valve with a plurality of switch levels, each of the plurality of electrical devices defining a respective one of the plurality of switch levels.

12. A testing assembly (20,120,220) according to Claim 11 wherein the switch valve is a thyristor valve (24) and each switch level is a thyristor level (T1, T2, T3, T4, T5, T6, T7, T8, T9, T10, T11, T12).

13. A testing assembly (220) according to Claim 11 or Claim 12 wherein an end switch level of the switch valve is short-circuited to another end switch level of the switch valve.

14. A testing assembly (20,120,220) according to any one of the preceding claims wherein each electrical coupler includes a switching element (S1, S2, S3, S4, S5, S6, S7, S8, S9, S10, S11, S12, S13, S14, SS11, SS31, SS51, SS71, SS91, SS111, SS131) which is switchable to selectively form and break an electrical connection.

15. A testing assembly (20,120,220) according to any one of the preceding claims further including a testing circuit controller (36) programmed to selectively control the or each testing circuit (22) to carry out at least one electrical test on the or each selected electrical device.
